(19) Europäisches Patentamt
European Patent Office
Office européen des brevets

(11) **EP 4 756 452 A1**

(12) **EUROPEAN PATENT APPLICATION**
published in accordance with Art. 153(4) EPC

(43) Date of publication:
**10.06.2026 Bulletin 2026/24**

(21) Application number: **24863143.4**

(22) Date of filing: **02.09.2024**

(51) International Patent Classification (IPC):
**G01R 31/392** (2019.01)     **G01R 31/382** (2019.01)
**G01R 31/385** (2019.01)     **G01R 31/36** (2020.01)
**G01R 19/165** (2006.01)     **G01R 31/371** (2019.01)
**B60L 58/16** (2019.01)

(52) Cooperative Patent Classification (CPC):
**B60L 58/16; G01R 19/165; G01R 31/36;
G01R 31/371; G01R 31/382; G01R 31/385;
G01R 31/392; Y02E 60/10**

(86) International application number:
**PCT/KR2024/013181**

(87) International publication number:
**WO 2025/053562 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **08.09.2023 KR 20230119561**

(71) Applicant: **LG Energy Solution, Ltd.
Seoul 07335 (KR)**

(72) Inventor: **JUNG, Joong Heum
Daejeon 34122 (KR)**

(74) Representative: **Plasseraud IP
104 Rue de Richelieu
CS92104
75080 Paris Cedex 02 (FR)**

(54) **BATTERY MANAGEMENT DEVICE AND OPERATION METHOD THEREOF**

(57) A battery management apparatus according to an embodiment disclosed herein includes an information obtaining unit configured to obtain an open circuit voltage (OCV) of a first battery corresponding to a first time from an external device, a reference OCV calculating unit configured to calculate a reference OCV of a battery corresponding to a time, and a controller configured to compare a reference OCV calculated to correspond to the first time with an OCV of the first battery corresponding to the first time to determine whether the first battery has a low voltage.

<u>200</u>

FIG.1

EP 4 756 452 A1

## Description

### TECHNICAL FIELD

### CROSS-REFERENCE TO RELATED APPLICATION

This application claims priority to and the benefit of Korean Patent Application No. 10-2023-0119561 filed in the Korean Intellectual Property Office on September 8, 2023, the entire content of which is incorporated herein by reference.

### TECHNICAL FIELD

Embodiments disclosed herein relate to a battery management apparatus and an operating method thereof.

### BACKGROUND ART

Recently, research and development of secondary batteries have been actively performed. Herein, the secondary batteries, which are chargeable/-dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Newly manufactured batteries are often stored for long periods of time before they are assembled into devices using the same. A low-voltage phenomenon may occur in an abnormal battery in which an open circuit voltage (OPC) decreases more greatly than in other batteries, and performance of the abnormal battery is lower than a normal battery. Accordingly, there is a need for a method for accurately determining whether a battery has a low voltage.

### DISCLOSURE

### TECHNICAL PROBLEM

Embodiments disclosed herein aim to accurately determine whether a battery has a low voltage after an elapse of a long time.

Embodiments disclosed herein aim to provide a battery management apparatus and an operating method thereof to prevent a battery from being coupled to a device using the battery in a low-voltage state of the battery.

Technical problems of the embodiments disclosed herein are not limited to the above-described technical problems, and other unmentioned technical problems would be clearly understood by one of ordinary skill in the art from the following description.

### TECHNICAL SOLUTION

A battery management apparatus according to an embodiment disclosed herein includes an information obtaining unit configured to obtain an open circuit voltage (OCV) of a first battery corresponding to a first time from an external device, a reference OCV calculating unit configured to calculate a reference OCV of a battery corresponding to a time, and a controller configured to compare a reference OCV calculated to correspond to the first time with an OCV of the first battery corresponding to the first time to determine whether the first battery has a low voltage.

In an embodiment, the first time may include at least any one of after the first battery is transported, after the first battery is transported and stored, or in a period of time when the first battery is to be assembled to the vehicle.

In an embodiment, the reference OCV calculating unit may be further configured to calculate the reference OCV of the battery corresponding to the time, based on an OCV of the battery corresponding to a second time, in which the second time precedes the first time.

In an embodiment, the second time may be a time of an end-of-line test of the battery.

In an embodiment, the information obtaining unit may be further configured to obtain an OCV of each of a plurality of batteries corresponding to a time, and the reference OCV calculating unit may be further configured to calculate an abnormal OCV based on the OCV of each of the plurality of batteries at intervals of a third time from the second time and calculate a regression equation for calculating the reference OCV, based on the abnormal OCV derived at intervals of the third time.

In an embodiment, the reference OCV calculating unit may be further configured to calculate a probability distribution based on a difference between an OCV of each of the plurality of batteries corresponding to the second time and the OCV of each of the plurality of batteries at intervals of the third time and calculate, as the abnormal OCV, a highest value among OCVs out of a normal range, based on the probability distribution.

In an embodiment, the reference OCV calculating unit may be further configured to calculate the regression equation through Equation 1,

[Equation 1]

$$Y = \alpha * \exp(-\beta * t^{\gamma})$$

Y: OCV, t: Time Elapsed, α: OCV of Second Time, β, Y: Shape Variable

In an embodiment, the reference OCV may be a reference OCV for determining the low voltage of the battery corresponding to the time.

In an embodiment, the controller may be further configured to transmit, to the external device, whether the first battery has the low voltage.

An operating method of a battery management apparatus, according to an embodiment disclosed herein includes obtaining an open circuit voltage (OCV) of a first battery corresponding to a first time from an external device, calculating a reference OCV of a battery corresponding to a time, and comparing a reference OCV calculated to correspond to the first time with an OCV of the first battery corresponding to the first time to determine whether the first battery has a low voltage.

In an embodiment, the first time may include after the battery is transported, after the battery is transported and stored, and immediately before the battery is assembled to the vehicle.

In an embodiment, the calculating of the reference OCV of the battery corresponding to the time may include calculating the reference OCV of the battery corresponding to the time, based on an OCV of the battery corresponding to a second time, in which the second time precedes the first time.

In an embodiment, the second time may be a time of an end-of-line test of the battery.

In an embodiment, the operating method may further include obtaining the OCV of each of the plurality of batteries corresponding to the time, in which the calculating of the reference OCV of the battery corresponding to the time includes calculating an abnormal OCV based on the OCV of each of the plurality of batteries at intervals of a third time from the second time and calculating a regression equation for calculating the reference OCV, based on the abnormal OCV derived at intervals of the third time.

In an embodiment, the calculating of the abnormal OCV based on the OCV of each of the plurality of batteries at intervals of the third time from the second time may include calculating a probability distribution based on a difference between an OCV of each of the plurality of batteries corresponding to the second time and the OCV of each of the plurality of batteries at intervals of the third time and calculating, as the abnormal OCV, a highest value among OCVs out of a normal range, based on the probability distribution.

In an embodiment, the calculating of the regression equation for calculating the reference OCV, based on the abnormal OCV derived at intervals of the third time may include calculating the regression equation through Equation 2,

[Equation 2]

$$Y=\alpha * \exp(-\beta * t^{\gamma})$$

Y: OCV, t: Time Elapsed, α: OCV of Second Time, β, Y: Shape Variable

In an embodiment, the reference OCV may be a reference OCV for determining the low voltage of the battery corresponding to the time.

In an embodiment, the operating method may further include transmitting, to the external device, whether the first battery has the low voltage.

## ADVANTAGEOUS EFFECTS

A battery management apparatus and an operating method thereof according to an embodiment disclosed herein may determine whether a battery has a low voltage after storage of a battery for a long time.

The battery management apparatus and the operating method thereof according to an embodiment disclosed herein may calculate a reference open circuit voltage (OCV) based on OCVs of a plurality of batteries every reference times and determine whether the battery has a low voltage based on a regression equation corresponding to a reference OCV.

The battery management apparatus and the operating method thereof according to an embodiment disclosed herein may determine whether a battery has a low voltage before the battery is assembled to a device using the battery, thereby preventing a defective battery from being used.

In addition, various effects identified directly or indirectly through this document may be provided.

## DESCRIPTION OF DRAWINGS

FIG.1 is a block diagram of a battery management apparatus according to an embodiment disclosed herein.

FIG.2 is a signal flowchart showing an example in which a battery management apparatus communicates with an external device, according to an embodiment disclosed herein.

FIG.3 shows an example in which a battery management apparatus calculates a reference open circuit voltage (OCV), according to an embodiment disclosed herein.

FIG.4 shows an example in which a battery management apparatus calculates a regression equation, according to an embodiment disclosed herein.

FIG.5 is a flowchart showing an operating method of a battery management apparatus according to an embodiment disclosed herein.

FIGS. 6 and 7 are flowcharts showing in detail an operating method of a battery management apparatus according to an embodiment disclosed herein. FIG.8 is a block diagram showing a hardware configuration of a computing system for performing an operating method of a battery management apparatus, according to an embodiment disclosed herein.

## MODE FOR INVENTION

Hereinafter, embodiments disclosed herein will be described in detail through exemplary drawings. In adding reference numerals to components of each drawing, it should be noted that the same components have the same numerals as much as possible even though they are displayed on different drawings. Moreover, in describing the embodiments disclosed herein, when it is determined that a detailed description of a related known configuration or function interferes with understanding of the embodiment disclosed herein, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. The terms defined in a generally used dictionary should be interpreted as having the same meanings as the contextual meanings of the relevant technology and should not be interpreted as having ideal or exaggerated meanings unless they are clearly defined in the present application.

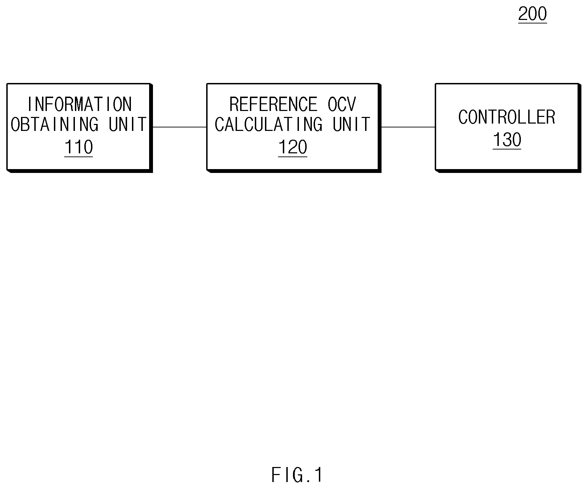

FIG.1 is a block diagram of a battery management apparatus according to an embodiment disclosed herein.

Referring to FIG.1, a battery management apparatus 100 according to an embodiment disclosed herein may include an information obtaining unit 110, a reference open circuit voltage (OCV) calculating unit 120, and a controller 130. According to an embodiment, an operation of the reference OCV calculating unit 120 may be performed by the controller 130.

The battery management apparatus 100 may be one of various electronic devices for managing, diagnosing, or testing a battery. For example, the battery management apparatus 100 may be included in a battery management system (BMS) in and outside a vehicle, or may be implemented as a separate external device different from the BMS in the vehicle. According to an embodiment, the battery management apparatus 100 may be included in an apparatus for a charging/discharging test such as a server, a cloud server, or a charging/-discharging cycler or may be included in various devices for diagnosing or testing the battery.

The information obtaining unit 110 may obtain an OCV of a first battery corresponding to a first time. For example, the information obtaining unit 110 may obtain the OCV of the first battery corresponding to the first time from an external device. According to an embodiment, the external device may include a device for using the first battery or a device related to a user for using the first battery.

According to an embodiment, the first time may include at least one of after the first battery is transported, after the first battery is transported and stored, or immediately before the first battery is assembled to the vehicle. For example, the external device may transmit a time from production to transport of the first battery, together with the OCV of the first battery, to the battery management apparatus 100. In another example, the external device may transmit a time from transport to storage of the first battery, together with the OCV of the first battery, to the battery management apparatus 100. In another example, the external device may transmit a period of time in which the first battery is to be assembled to the vehicle, together with the OCV of the first battery, to the battery management apparatus 100. That is, the battery management apparatus 100 may receive, from the external device, a time corresponding to at least any one of after the first battery is transported, after the first battery is transported and stored, or in a period of time in which the first battery is to be assembled to the vehicle, and the OCV of the first battery, and determine whether the first battery has a low voltage corresponding to at least any one of after the first battery is transported, after the first battery is transported and stored, or in the period of time in which the first battery is to be assembled to the vehicle. Thus, before the first battery is used, the battery management apparatus 100 may sense the low voltage of the first battery and prevent the first battery from being used.

According to an embodiment, the external device 100 may transmit date information after the first battery is transported and stored, together with the OCV of the first battery, to the battery management apparatus 100 which may then compare the date information after the first battery is transported and stored with a date on which the first battery is produced to identify a time elapsed from production of the first battery, and diagnose whether the first battery has the low voltage based on the elapsed time and the OCV of the first battery.

According to an embodiment, the low voltage of the battery may refer to, but not limited to, a phenomenon in which an OCV decreases by at least a set value compared to a decrease in OCV of a normal battery over time. For example, the low-voltage battery may have lower performance than the normal battery.

The information obtaining unit 110 may further obtain an OCV of each of the plurality of batteries corresponding to a time. For example, the plurality of batteries are batteries for defining criteria different from the first battery, and may be used to calculate the reference OCV in the reference OCV calculating unit 120. According to an embodiment, the plurality of batteries may include batteries of a number required for setting the reference OCV of the battery. For example, the plurality of batteries may include, but not limited to, 100 batteries.

The reference OCV calculating unit 120 may calculate the reference OCV of the battery corresponding to a time. For example, the reference OCV may be a reference OCV for determining the low voltage of the battery corresponding to the time. In another example, the reference OCV may be a minimum OCV that should be expressed when the battery is not the low-voltage battery in case of an elapse of a certain period of time such as 5 days, 10 days, 20 days, etc., from production of the battery. According to an embodiment, the reference OCV may be calculated separately weekly, daily, hourly, and minutely after production of the battery. That is, the reference OCV may be calculated in a minimum time unit required for determining whether the battery has the low voltage.

Ther reference OCV calculating unit 120 may calculate the reference OCV of the battery corresponding to the time based on the OCV of the battery corresponding to a second time. For example, the second time may precede the first time. According to an embodiment, the second time may be a time of an end-of-line test of the battery. That is, the battery management apparatus 100 may calculate the reference OCV based on the OCV of the battery immediately after production of the battery.

According to an embodiment, the reference OCV calculating unit 120 may calculate an abnormal OCV based on the OCV of each of the plurality of batteries at intervals of a third time from the second time. For example, the reference OCV calculating unit 120 may calculate a difference between an OCV of each of the plurality of batteries corresponding to a second reference time and an OCV of each of the plurality of batteries at intervals of the third time, and calculate a probability distribution based on the calculated difference. For example, the reference OCV calculating unit 120 may calculate the probability distribution based on a normal distribution. In this case, the reference OCV calculating unit 120 may calculate, as an abnormal OCV, the highest value among OCVs out of a normal range, based on the probability distribution. For example, the reference OCV calculating unit 120 may calculate, as the abnormal OCV, the highest value among OCVs out of the normal range (e.g., at least 99 %, at least 2 sigma, etc.) in the probability distribution to calculate the reference OCV that is a criterion for determining a low voltage.

The reference OCV calculating unit 120 may calculate a regression equation for calculating the reference OCV based on the abnormal OCV derived at intervals of the third time. For example, the reference OCV calculating unit 120 may calculate the regression equation through Equation 1.

[Equation 1]

$$Y = \alpha * \exp(-\beta * t^{\gamma})$$

Y: OCV, t: Time Elapsed, $\alpha$: OCV of Second Time, $\beta$, $\gamma$: Shape Variable

According to an embodiment, the reference OCV calculating unit 120 may calculate $\alpha$, $\beta$, and $\gamma$ by fitting Equation 1 based on the abnormal OCV derived at intervals of the third time. In this case, the reference OCV calculating unit 120 may substitute the OCV of the second time for the first battery to $\alpha$ while fixing the shape variables $\beta$ and $\gamma$, and substitute the first time to t, thereby calculating a reference OCV corresponding to the first time for the first battery.

According to an embodiment, the third time may be set arbitrarily and set to, but not limited to, 7 days. As the third time decreases, the sample of the abnormal OCV may increase, such that a regression equation of a high accuracy may be calculated, but a regression equation for accurately determining a low voltage may be calculated even for the third time being long.

The controller 130 may compare the reference OCV calculated to correspond to the first time with the OCV of the first battery corresponding to the first time to determine whether the first battery has the low voltage. For example, the controller 130 may compare the OCV of the first battery corresponding to at least one of after the first battery is transported, after the first battery is transported and stored, or immediately before the first battery is assembled to the vehicle with the reference OCV calculated to correspond to the first time, thereby determining whether the first battery has the low voltage. According to an embodiment, the controller 130 may determine that the first battery is at the low voltage when the OCV of the first battery corresponding to the first time is less than or less than or equal to the reference OCV calculated to correspond to the first time.

According to an embodiment, the controller 130 may transmit whether the first battery has the low voltage to the external device. In this case, the external device may receive whether the first battery has the low voltage to provide guidance to a user, and further determine whether the first battery is available, based on whether the first battery has the low voltage.

The battery management apparatus 100 according to an embodiment disclosed herein may determine whether the battery has the low voltage after storage of the battery for a long time.

The battery management apparatus 100 according to an embodiment disclosed herein may calculate a reference OCV based on OCVs of a plurality of batteries every reference times and determine a low voltage of the battery based on a regression equation corresponding to a reference OCV.

The battery management apparatus 100 according to an embodiment disclosed herein may determine whether the battery has the low voltage before the battery is assembled to a device using the battery, thereby preventing a defective battery from being used.

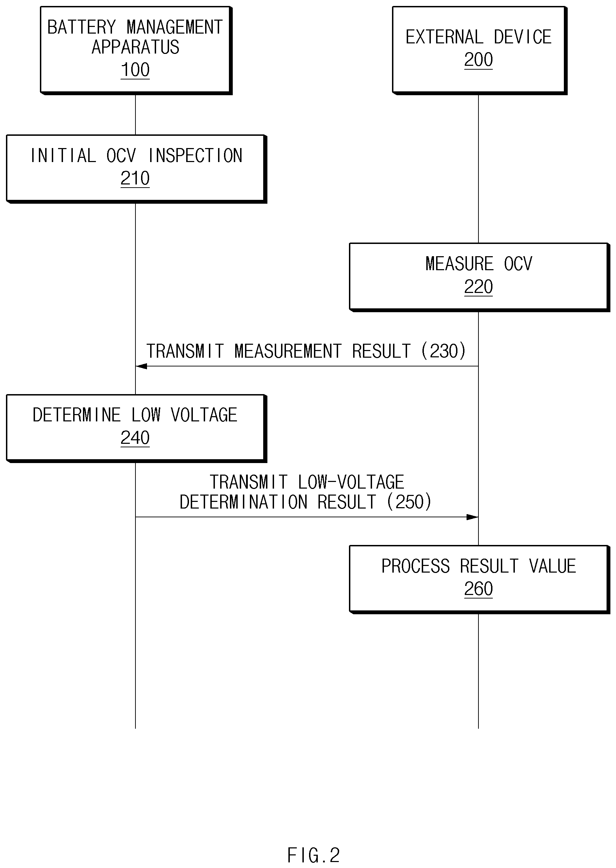

FIG.2 is a signal flowchart showing an example in which a battery management apparatus communicates with an external device, according to an embodiment disclosed herein. According to an embodiment, the battery management apparatus 100 shown in FIG.2 may be substantially the same as the battery management apparatus 100 of FIG.1 .

Referring to FIG.2, the battery management apparatus 100 may perform initial OCV inspection of the battery in operation 210. For example, the initial OCV inspection may be absolute decision inspection, and the battery management apparatus 100 may determine whether the battery has the low voltage, based on a change in OCV for a preset period of time after production of the battery.

For the battery succeeding in the initial OCV inspection, corresponding information may be transmitted to the user using the battery. For example, the user using the battery may use an external device 200.

The external device 200 may measure the OCV of the battery in operation 220. For example, the external device 200 may measure the OCV of the battery in at least one time of after the battery is transported, after the battery is transported and stored, or immediately before the battery is assembled to the vehicle.

The external device 200 may transmit a measurement result to the battery management apparatus 100, in operation 230. For example, the external device 200 may transmit an OCV measurement result of the battery, a date (time) of OCV measurement, and identification information of the battery to the battery management apparatus 100.

The battery management apparatus 100 may determine the low voltage of the battery, based on the OCV measurement result of the battery, in operation 240. For example, the battery management apparatus 100 may calculate the reference OCV of the battery based on the initial OCV of the battery and a difference between a production time of the battery and a measurement time of the OCV of the battery, and determine whether the battery has the low voltage by comparing the calculated reference OCV with the OCV measurement result of the battery. According to an embodiment, the battery management apparatus 100 may determine that the battery has the low voltage, when the OCV measurement result of the battery is less than the reference OCV.

The battery management apparatus 100 may transmit a low-voltage determination result to the external device 200, in operation 250. For example, the battery management apparatus 100 may transmit the low-voltage determination result of the battery together with the identification information of the battery.

The external device 200 may process a result value in operation 260. For example, when it is determined that the battery has the low voltage, the external device 200 may guide corresponding information to the user. In another example, when it is determined that the battery has the low voltage, the external device 200 may request battery exchange and control not to use the battery.

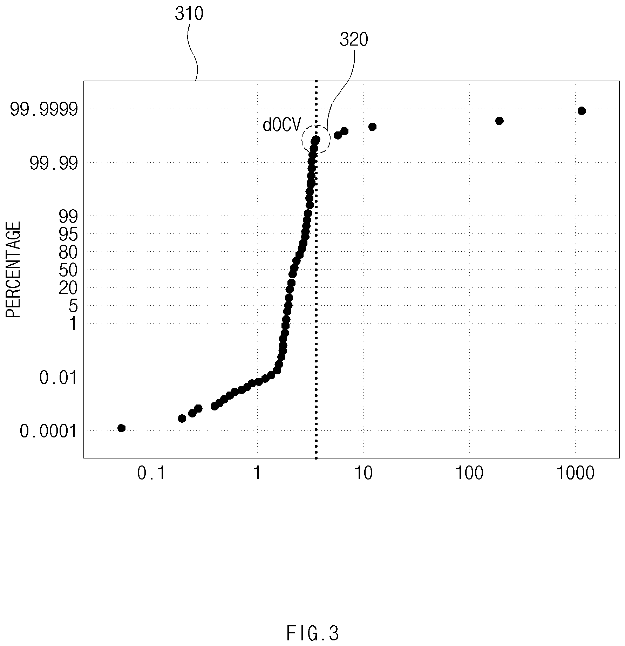

FIG.3 shows an example in which a battery management apparatus calculates a reference OCV, according to an embodiment disclosed herein.

Referring to FIG.3, the reference OCV calculating unit 120 of the battery management apparatus 100 according to an embodiment disclosed herein may calculate a reference OCV. For example, the reference OCV calculating unit 120 may calculate a difference between the initial OCV of each of the plurality of batteries and an OCV after an elapse of a specific time. In this case, the reference OCV calculating unit 120 may calculate a probability distribution 310 based on the calculated difference.

The reference OCV calculating unit 120 may calculate, as an abnormal OCV, a highest value 320 among OCVs out of a normal range, based on the probability distribution.

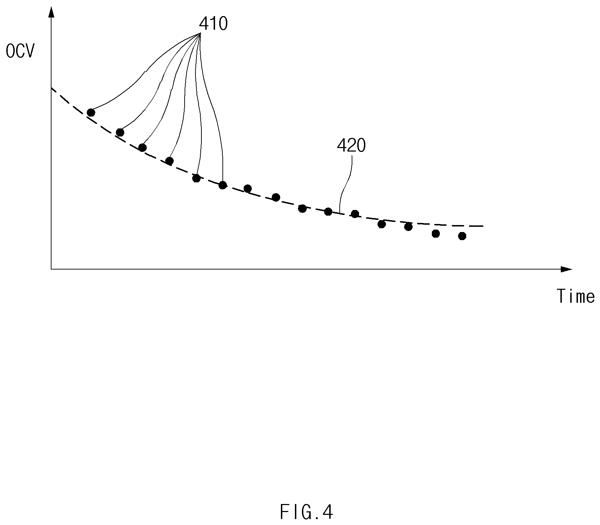

FIG.4 shows an example in which a battery management apparatus calculates a regression equation, according to an embodiment disclosed herein.

Referring to FIG.4, the reference OCV calculating unit 120 may calculate an abnormal OCV 410 at intervals of the third time. In this case, the reference OCV calculating unit 120 may fit the abnormal OCV 410 calculated at intervals of the third time based on an exponential-power model.

According to an embodiment, the reference OCV calculating unit 120 may fit the abnormal OCV 410 calculated at intervals of the third time to calculate a regression equation 420.

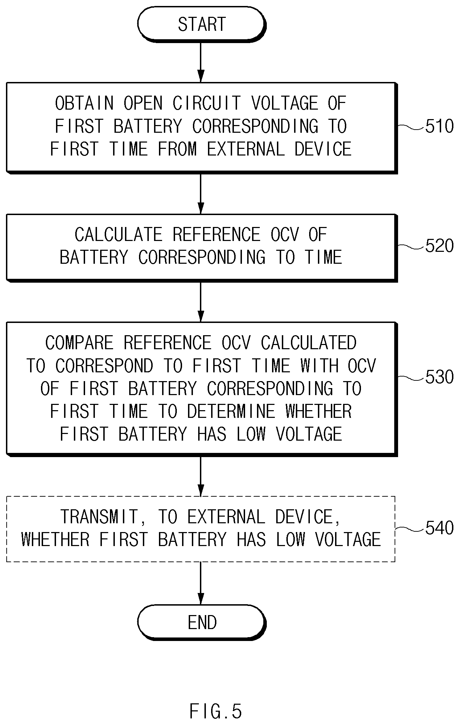

FIG.5 is a flowchart showing an operating method of a battery management apparatus according to an embodiment disclosed herein. According to an embodiment, operations shown in FIG.5 may be performed by the battery management apparatus 100 of FIG.1.

Referring to FIG.5, in operation 510, the information obtaining unit 110 may obtain an OCV of the first battery corresponding to the first time from the external device. For example, the information obtaining unit 110 may obtain the OCV of the first battery corresponding to the first time from an external device. According to an embodiment, the external device may include a device for using the first battery or a device related to a user for using the first battery.

According to an embodiment, the first time may include at least one of after the first battery is transported, after the first battery is transported and stored, or immediately before the first battery is assembled to the vehicle. For example, the external device may transmit a time from production to transport of the first battery, together with the OCV of the first battery, to the battery management apparatus 100. In another example, the external device may transmit a time from transport to storage of the first battery, together with the OCV of the first battery, to the battery management apparatus 100. In another example, the external device may transmit a period of time in which the first battery is to be assembled to the vehicle, together with the OCV of the first battery, to the battery management apparatus 100. That is, the battery management apparatus 100 may receive, from the external device, a time corresponding to at least any one of after the first battery is transported, after the first battery is transported and stored, or in a period of time in which the first battery is to be assembled to the vehicle, and the OCV of the first battery, and determine whether the first battery has a low voltage corresponding to at least any one of after the first battery is transported, after the first battery is transported and stored, or in the period of time in which the first battery is to be assembled to the vehicle. Thus, before the first battery is used, the battery management apparatus 100 may sense the low voltage of the first battery and prevent the first battery from being used.

According to an embodiment, the external device 100 may transmit date information after the first battery is transported and stored, together with the OCV of the first battery, to the battery management apparatus 100 which may then compare the date information after the first battery is transported and stored with a date on which the first battery is produced to identify a time elapsed from production of the first battery, and diagnose whether the first battery has the low voltage based on the elapsed time and the OCV of the first battery.

In operation 520, the reference OCV calculating unit 120 may calculate the reference OCV of the battery corresponding to a time. For example, the reference OCV may be a reference OCV for determining the low voltage of the battery corresponding to the time. In another example, the reference OCV may be a minimum OCV that should be expressed when the battery is not the low-voltage battery in case of an elapse of a certain period of time such as 5 days, 10 days, 20 days, etc., from production of the battery. According to an embodiment, the reference OC may be calculated separately weekly, daily, hourly, and minutely after production of the battery. That is, the reference OCV may be calculated in a minimum time unit required for determining whether the battery has the low voltage.

Ther reference OCV calculating unit 120 may calculate the reference OCV of the battery corresponding to the time based on the OCV of the battery corresponding to the second time. For example, the second time may precede the first time. According to an embodiment, the second time may be a time of an end-of-line test of the battery. That is, the battery management apparatus 100 may calculate the reference OCV based on the OCV of the battery immediately after production of the battery.

In operation 530, the controller 130 may compare the reference OCV calculated to correspond to the first time with the OCV of the first battery corresponding to the first time to determine whether the first battery has the low voltage. For example, the controller 130 may compare the OCV of the first battery corresponding to at least one of after the first battery is transported, after the first battery is transported and stored, or immediately before the first battery is assembled to the vehicle with the reference OCV calculated to correspond to the first time, thereby determining whether the first battery has the low voltage. According to an embodiment, the controller 130 may determine that the first battery is at the low voltage when the OCV of the first battery corresponding to the first time is less than or less than or equal to the reference OCV calculated to correspond to the first time.

In operation 540, the controller 130 may transmit whether the first battery has the low voltage to the external device. In this case, the external device may receive whether the first battery has the low voltage to provide guidance to a user, and further determine whether the first battery is available, based on whether the first battery has the low voltage. According to an embodiment, operation 540 may be omitted.

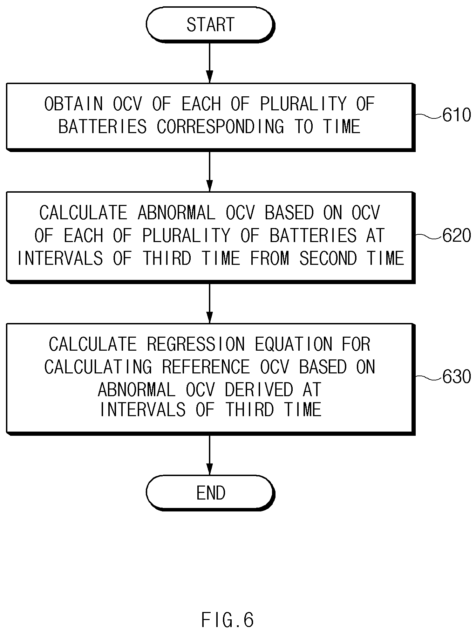

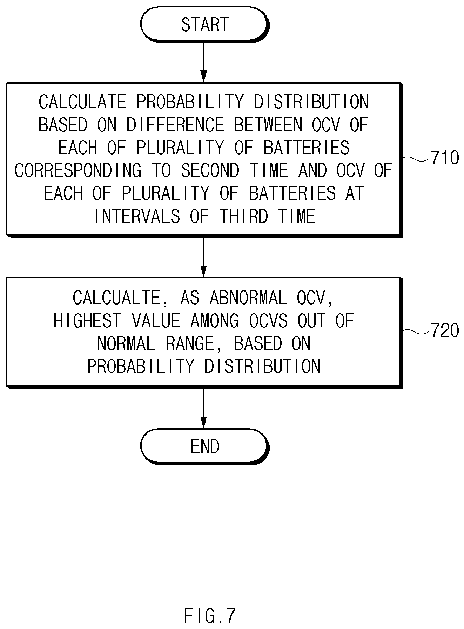

FIGS. 6 and 7 are flowcharts showing in detail an operating method of a battery management apparatus according to an embodiment disclosed herein. According to an embodiment, operations shown in FIGS. 6 and 7 may be performed by the battery management apparatus 100 of FIG.1 .

Referring to FIG.6, in operation 610, the information obtaining unit 110 may obtain an OCV of each of the plurality of batteries corresponding to a time. For example, the plurality of batteries are batteries for defining criteria different from the first battery, and may be used to calculate the reference OCV in the reference OCV calculating unit 120 described below. According to an embodiment, the plurality of batteries may include batteries of a number required for setting the reference OCV of the battery. For example, the plurality of batteries may include, but not limited to, 100 batteries.

In operation 620, the reference OCV calculating unit 120 may calculate the abnormal OCV based on the OCV of each of the plurality of batteries at intervals of the third time from the second time.

In operation 630, the reference OCV calculating unit 120 may calculate the regression equation for calculating the reference OCV based on the abnormal OCV derived at intervals of the third time. For example, the reference OCV calculating unit 120 may calculate the regression equation for calculating the reference OCV based on the abnormal OCV derived at intervals of the third time. For example, the reference OCV calculating unit 120 may calculate the regression equation through Equation 2.

[Equation 2]

$$Y = \alpha * \exp(-\beta * t^{\gamma})$$

Y: OCV, t: Time Elapsed, α: OCV of Second Time, β, Y: Shape Variable

According to an embodiment, the reference OCV calculating unit 120 may calculate α, β, and γ by fitting Equation 1 based on the abnormal OCV derived at intervals of the third time. In this case, the reference OCV calculating unit 120 may substitute the OCV of the second time for the first battery to α while fixing the shape variables β and γ, and substitute the first time to t, thereby calculating a reference OCV corresponding to the first time for the first battery.

According to an embodiment, the third time may be set arbitrarily and set to, but not limited to, 7 days. As the third time decreases, the sample of the abnormal OCV may increase, such that a regression equation of a high accuracy may be calculated, but a regression equation for accurately determining a low voltage may be calculated even for the third time being long.

According to an embodiment, operations 620 and 630 may be included in operation 520 of FIG.5.

Referring to FIG.7, in operation 710, the reference OCV calculating unit 120 may calculate a probability distribution based on the OCV of each of the plurality of batteries corresponding to the second time and the OCV of each of the plurality of batteries at intervals of the third time. For example, the reference OCV calculating unit 120 may calculate the probability distribution based on the normal distribution.

In operation 720, the reference OCV calculating unit 120 may calculate, as an abnormal OCV, the highest value among OCVs out of a normal range, based on the probability distribution. For example, the reference OCV calculating unit 120 may calculate, as the abnormal OCV, the highest value among OCVs out of the normal range (e.g., at least 99 %, at least 2 sigma, etc.) in the probability distribution to calculate the reference OCV that is a criterion for determining the low voltage.

According to an embodiment, operations 710 and 720 may be included in operation 620 of FIG.6.

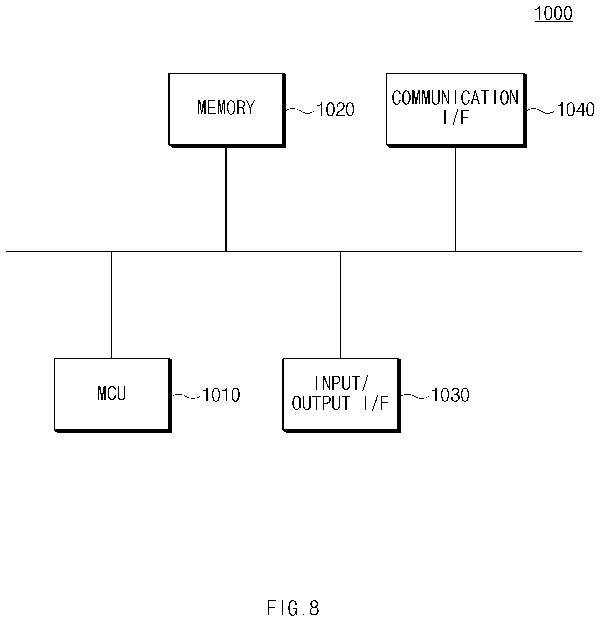

FIG.8 is a block diagram showing a hardware configuration of a computing system for performing an operating method of a battery management apparatus, according to an embodiment disclosed herein.

Referring to FIG.8, a computing system 1000 according to an embodiment disclosed herein may include a microcontroller unit (MCU) 1010, a memory 1020, an input/output interface (I/F) 1030, and a communication I/F 1040.

The MCU 1010 may be a processor that executes various programs (e.g., a battery reference OCV calculation program, a battery low-voltage determination program, etc.) stored in the memory 1020, processes various information including an OCV, a reference OCV, a low voltage of the battery, etc., through these programs, and executes the above-described functions of the controller included in the battery determination apparatus shown in FIG.1.

The memory 1020 may store various programs such as the battery reference OCV calculation program, the battery low-voltage determination program, etc. Moreover, the memory 1020 may store various information such as the OCV, the reference OCV, the low voltage of the battery, etc.

The memory 1020 may be provided in plural, depending on a need. The memory 1020 may be a volatile or nonvolatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., with the MCU 1010.

The communication I/F 1040, which is a component capable of transmitting and receiving various data to and from a server, may be various types of devices capable of supporting wired or wireless communication. For example, the battery management apparatus may transmit and receive various information including the OCV, the reference OCV, the low voltage of the battery, etc., to and from a separately provided external server through the communication I/F 1040.

As such, a computer program according to an embodiment disclosed herein may be recorded in the memory 1020 and processed by the MCU 1010, thus being implemented as a module that performs functions shown in FIG.1.

The above description is merely illustrative of the technical idea disclosed herein, and various modifications and variations will be possible without departing from the essential characteristics of the embodiments disclosed herein by those of ordinary skill in the art to which the embodiments disclosed herein pertains.

Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

**Claims**

1. A battery management apparatus comprising:

an information obtaining unit configured to obtain an open circuit voltage (OCV) of a first battery corresponding to a first time from an external device;

a reference OCV calculating unit configured to calculate a reference OCV of a battery corresponding to a time; and

a controller configured to compare a reference OCV calculated to correspond to the first time with an OCV of the first battery corresponding to the first time to determine whether the first battery has a low voltage.

2. The battery management apparatus of claim 1, wherein the first time comprises at least any one of after the first battery is transported, after the first battery is transported and stored, or in a period of time when the first battery is to be assembled to the vehicle.

3. The battery management apparatus of claim 1, wherein the reference OCV calculating unit is further configured to calculate the reference OCV of the battery corresponding to the time, based on an OCV of the battery corresponding to a second time, wherein the second time precedes the first time.

4. The battery management apparatus of claim 3, wherein the second time is a time of an end-of-line test of the battery.

5. The battery management apparatus of claim 3, wherein the information obtaining unit is further configured to obtain an OCV of each of a plurality of batteries corresponding to a time, and the reference OCV calculating unit is further configured to:

calculate an abnormal OCV based on the OCV of each of the plurality of batteries at intervals of a third time from the second time; and
calculate a regression equation for calculating the reference OCV, based on the abnormal OCV derived at intervals of the third time.

6. The battery management apparatus of claim 5, wherein the reference OCV calculating unit is further configured to:

calculate a probability distribution based on a difference between an OCV of each of the plurality of batteries corresponding to the second time and the OCV of each of the plurality of batteries at intervals of the third time; and
calculate, as the abnormal OCV, a highest value among OCVs out of a normal range, based on the probability distribution.

7. The battery management apparatus of claim 5, wherein the reference OCV calculating unit is further configured to calculate the regression equation through Equation 1,

[Equation 1]

$$Y = \alpha * \exp(-\beta * t^{\gamma})$$

Y: OCV, t: Time Elapsed, α: OCV of Second Time, β, Y: Shape Variable

8. The battery management apparatus of claim 1, wherein the reference OCV is a reference OCV for determining the low voltage of the battery corresponding to the time.

9. The battery management apparatus of claim 1, wherein the controller is further configured to transmit, to the external device, whether the first battery has the low voltage.

10. An operating method of a battery management apparatus, the operating method comprising:

obtaining an open circuit voltage (OCV) of a first battery corresponding to a first time from an external device;
calculating a reference OCV of a battery corresponding to a time; and
comparing a reference OCV calculated to correspond to the first time with an OCV of the first battery corresponding to the first time to determine whether the first battery has a low voltage.

11. The operating method of claim 10, wherein the first time comprises after the battery is transported, after the battery is transported and stored, and immediately before the battery is assembled to the vehicle.

12. The operating method of claim 10, wherein the calculating of the reference OCV of the battery corresponding to the time comprises calculating the reference OCV of the battery corresponding to the time, based on an OCV of the battery corresponding to a second time, wherein the second time precedes the first time.

13. The operating method of claim 12, wherein the second time is a time of an end-of-line test of the battery.

14. The operating method of claim 12, further comprising obtaining the OCV of each of the plurality of batteries corresponding to the time, wherein the calculating of the reference OCV of the battery corresponding to the time comprises:

calculating an abnormal OCV based on the OCV of each of the plurality of batteries at intervals of a third time from the second time; and calculating a regression equation for calculating the reference OCV, based on the abnormal OCV derived at intervals of the third time.

15. The operating method of claim 14, wherein the calculating of the abnormal OCV based on the OCV of each of the plurality of batteries at intervals of the third time from the second time comprises:

calculating a probability distribution based on a difference between an OCV of each of the plurality of batteries corresponding to the second time and the OCV of each of the plurality of batteries at intervals of the third time; and calculating, as the abnormal OCV, a highest value among OCVs out of a normal range, based on the probability distribution.

16. The operating method of claim 14, wherein the calculating of the regression equation for calculating the reference OCV, based on the abnormal OCV derived at intervals of the third time comprises calculating the regression equation through Equation 2,

[Equation 2]

$$Y = \alpha * \exp(-\beta * t^{\gamma})$$

Y: OCV, t: Time Elapsed, $\alpha$: OCV of Second Time, $\beta$, $Y$: Shape Variable

17. The operating method of claim 10, wherein the reference OCV is a reference OCV for determining the low voltage of the battery corresponding to the time.

18. The operating method of claim 10, further comprising transmitting, to the external device, whether the first battery has the low voltage.

200

| INFORMATION OBTAINING UNIT 110 | REFERENCE OCV CALCULATING UNIT 120 | CONTROLLER 130 |

FIG.1

BATTERY MANAGEMENT
APPARATUS
100

EXTERNAL DEVICE
200

INITIAL OCV INSPECTION
210

MEASURE OCV
220

TRANSMIT MEASUREMENT RESULT (230)

DETERMINE LOW VOLTAGE
240

TRANSMIT LOW-VOLTAGE
DETERMINATION RESULT (250)

PROCESS RESULT VALUE
260

FIG.2

FIG.3

FIG.4

START

OBTAIN OPEN CIRCUIT VOLTAGE OF
FIRST BATTERY CORRESPONDING TO
FIRST TIME FROM EXTERNAL DEVICE ⸺510

CALCULATE REFERENCE OCV OF
BATTERY CORRESPONDING TO TIME ⸺520

COMPARE REFERENCE OCV CALCULATED
TO CORRESPOND TO FIRST TIME WITH OCV
OF FIRST BATTERY CORRESPONDING TO ⸺530
FIRST TIME TO DETERMINE WHETHER
FIRST BATTERY HAS LOW VOLTAGE

TRANSMIT, TO EXTERNAL DEVICE,
WHETHER FIRST BATTERY HAS LOW VOLTAGE ⸺540

END

FIG.5

START

OBTAIN OCV OF EACH OF PLURALITY OF
BATTERIES CORRESPONDING TO TIME — 610

CALCULATE ABNORMAL OCV BASED ON OCV
OF EACH OF PLURALITY OF BATTERIES AT — 620
INTERVALS OF THIRD TIME FROM SECOND TIME

CALCULATE REGRESSION EQUATION FOR
CALCULATING REFERENCE OCV BASED ON
ABNORMAL OCV DERIVED AT — 630
INTERVALS OF THIRD TIME

END

FIG.6

START

CALCULATE PROBABILITY DISTRIBUTION
BASED ON DIFFERENCE BETWEEN OCV OF
EACH OF PLURALITY OF BATTERIES
CORRESPONDING TO SECOND TIME AND OCV OF
EACH OF PLURALITY OF BATTERIES AT
INTERVALS OF THIRD TIME
— 710

CALCUALTE, AS ABNORMAL OCV,
HIGHEST VALUE AMONG OCVS OUT OF
NORMAL RANGE, BASED ON
PROBABILITY DISTRIBUTION
— 720

END

FIG.7

1000

| | |
|---|---|
| MEMORY 〜1020 | COMMUNICATION I/F 〜1040 |

| | |
|---|---|
| MCU 〜1010 | INPUT/ OUTPUT I/F 〜1030 |

FIG.8

## INTERNATIONAL SEARCH REPORT

| International application No. |
|---|
| **PCT/KR2024/013181** |

### A. CLASSIFICATION OF SUBJECT MATTER

**G01R 31/392**(2019.01)i; **G01R 31/382**(2019.01)i; **G01R 31/385**(2019.01)i; **G01R 31/36**(2006.01)i; **G01R 19/165**(2006.01)i; **G01R 31/371**(2019.01)i; **B60L 58/16**(2019.01)i

According to International Patent Classification (IPC) or to both national classification and IPC

### B. FIELDS SEARCHED

Minimum documentation searched (classification system followed by classification symbols)

G01R 31/392(2019.01); G01R 31/36(2006.01); G01R 31/382(2019.01); H01M 10/052(2010.01); H01M 10/058(2010.01); H01M 10/42(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 개방 회로 전압(open circuit voltage), 기준 OCV(reference OCV), 저 전압(low voltage), 회귀식(regression equation)

### C. DOCUMENTS CONSIDERED TO BE RELEVANT

| Category* | Citation of document, with indication, where appropriate, of the relevant passages | Relevant to claim No. |
|---|---|---|
| X | KR 10-1779245 B1 (LG CHEM, LTD.) 26 September 2017 (2017-09-26)<br>See paragraphs [0030]-[0054]. | 1,2,8,10,11,17 |
| Y | | 3,4,9,12,13,18 |
| A | | 5-7,14-16 |
| Y | JP 5804759 B2 (FURUKAWA ELECTRIC CO., LTD.) 04 November 2015 (2015-11-04)<br>See paragraph [0033] and claim 5. | 3,4,9,12,13,18 |
| A | KR 10-2023-0070812 A (LG ENERGY SOLUTION, LTD.) 23 May 2023 (2023-05-23)<br>See paragraphs [0118]-[0121]. | 1-18 |
| A | JP 2023-530691 A (LG ENERGY SOLUTION LTD.) 19 July 2023 (2023-07-19)<br>See paragraphs [0046]-[0072]. | 1-18 |

☑ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **05 December 2024** | **05 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2024/013181** |

| C. | DOCUMENTS CONSIDERED TO BE RELEVANT | |
| --- | --- | --- |
| Category* | Citation of document, with indication, where appropriate, of the relevant passages | Relevant to claim No. |
| A | US 2021-0199724 A1 (LG CHEM, LTD.) 01 July 2021 (2021-07-01) See paragraphs [0053]-[0089]. | 1-18 |

**INTERNATIONAL SEARCH REPORT**
**Information on patent family members**

International application No.

**PCT/KR2024/013181**

| Patent document cited in search report | | | Publication date (day/month/year) | Patent family member(s) | | | Publication date (day/month/year) |
|---|---|---|---|---|---|---|---|
| KR | 10-1779245 | B1 | 26 September 2017 | KR | 10-2015-0144558 | A | 28 December 2015 |
| JP | 5804759 | B2 | 04 November 2015 | JP | 2012-225740 | A | 15 November 2012 |
| | | | | WO | 2012-144516 | A1 | 26 October 2012 |
| KR | 10-2023-0070812 | A | 23 May 2023 | | None | | |
| JP | 2023-530691 | A | 19 July 2023 | CN | 115803937 | A | 14 March 2023 |
| | | | | EP | 4199182 | A1 | 21 June 2023 |
| | | | | JP | 7537664 | B2 | 21 August 2024 |
| | | | | KR | 10-2022-0139755 | A | 17 October 2022 |
| | | | | US | 2023-0296688 | A1 | 21 September 2023 |
| | | | | WO | 2022-215962 | A1 | 13 October 2022 |
| US | 2021-0199724 | A1 | 01 July 2021 | CN | 112534283 | A | 19 March 2021 |
| | | | | CN | 112534283 | B | 16 April 2024 |
| | | | | EP | 3872507 | A1 | 01 September 2021 |
| | | | | EP | 3872507 | B1 | 11 May 2022 |
| | | | | JP | 2021-533338 | A | 02 December 2021 |
| | | | | JP | 7155486 | B2 | 19 October 2022 |
| | | | | KR | 10-2020-0102927 | A | 01 September 2020 |
| | | | | US | 11567137 | B2 | 31 January 2023 |
| | | | | WO | 2020-171442 | A1 | 27 August 2020 |

Form PCT/ISA/210 (patent family annex) (July 2022)

**EP 4 756 452 A1**

**Patent documents cited in the description**

- KR 1020230119561